Europäisches Patentamt

European Patent Office

Office européen des brevets

(11) Publication number: **0 264 239**
**A2**

## EUROPEAN PATENT APPLICATION

(21) Application number: 87308974.2

(22) Date of filing: 09.10.87

(51) Int. Cl.4: **H04Q 1/02** , H04Q 3/68

(30) Priority: 15.10.86 GB 8624695

(43) Date of publication of application:
20.04.88 Bulletin 88/16

(84) Designated Contracting States:
BE CH DE ES FR GR IT LI LU NL SE

(71) Applicant: PLESSEY OVERSEAS LIMITED
Vicarage Lane
Ilford Essex IGI 4AQ(GB)

(72) Inventor: Bennion, Ian
Linden House Guilsborough Road
Ravensthorpe Northants(GB)
Inventor: Williams, Roger Morley
Rowan Cottage Rochford Way Taplow
Maidenhead, Berks.(GB)

(74) Representative: Allen, Derek
The Plessey Company plc Intellectual
Property Department Vicarage Lane
Ilford Essex, IG1 4AQ(GB)

(54) An arrangement for linking multistage switching matrices.

(57) This invention is concerned with linking multistage switching matrices by means other than hardwired interconnections. Each link in an orthogonally arranged multistage switching block (A,B,C) is constituted by an electrmagnetic wave transmission path (TP). Outputs in one stage include an electromagnetic wave transmitting means (T) and inputs in adjacent stages include electromagnetic wave receiving means (R).

EP 0 264 239 A2

## An Arrangement for linking Multistage Switching Matrices

This invention relates to an arrangement for linking multistage switching matrices to form a multistage switching network. The invention has particular application to high capacity and high bandwidth switch networks employed in telecommunications systems and can be used for analogue, or digital, or time division multiplexed systems implemented in plug-in board and backplane type of assembly. Further, the method is applicable to switching matrices in which the switching elements are of the electrical or optical type.

In space and time division switching, multistage switching networks are known; methods of introducing blocking dependent upon the number of intermediate stages, the dimensions and the interconnection of the matrices are also known. A feature of a multistage switching network is the number of fixed interconnections or links between the stages. For example, in a three-stage non-blocking space switching network with N inputs and N outputs, the number of interstage connections required between the intermediate and the outer stages is 2N-N. It is also a feature of a multistage space switching network that the interstage connections carry a signal of the same frequency and bandwidth as that of the input to the switch.

In a high capacity switch for high frequency/high bandwidth signals, the interconnection of the switch stages through a backplane presents significant problems in implementation because of the quantity of these connections and the transmission characteristics required of them. Interference and crosstalk between connections are particular problems. Known methods of reducing the number of physical connections include time division, frequency division, or wavelength division multiplexing of several signals on to a smaller number of interconnected paths.

An aim of the invention is to provide an arrangement for linking multistage matrices which reduces the problems related to interconnection of the switch stages through a backplane and which minimises crosstalk and interference between connections through the matrices and facilitates high bandwidth switching networks.

According to the present invention, there is provided an arrangement for linking multistage matrices, wherein for any interstage link between an output in any stage and an input in an adjacent stage in the multistage matrices, an electromagnetic wave transmitting means is provided at said output and an electromagnetic wave receiving means is provided at said input and wherein the interstage link is constituted by an electromagnetic wave transmission path extending between said electromagnetic wave transmitting means and said electromagnetic wave receiving means.

The invention will be better understood from the following description of an exemplary embodiment which should be read in conjunction with the accompanying drawings in which;

Fig. 1 shows a diagrammatic representation of a typical non-blocking multistage switching network, which comprises three stages;

Fig. 2 shows a pictoral representation of the three-stage switching network of Fig. 1 to illustrate the orthogonal pattern of the switch planes and their interconnections;

Fig. 3 shows an orthogonal arrangement of a three-stage switching block including orthogonally arranged backplanes and including linking in accordance with this invention;

Fig. 4 a diagrammatic perspective of a portion of a switching network to illustrate the location of the transmission and receiver means mounted on adjacent orthogonally arranged p.c.b's in accordance with this invention; and,

Fig. 5 a perspective view of a portion of a double-sided guide into which the orthogonally arranged p.c.b's are inserted in accordance with this invention.

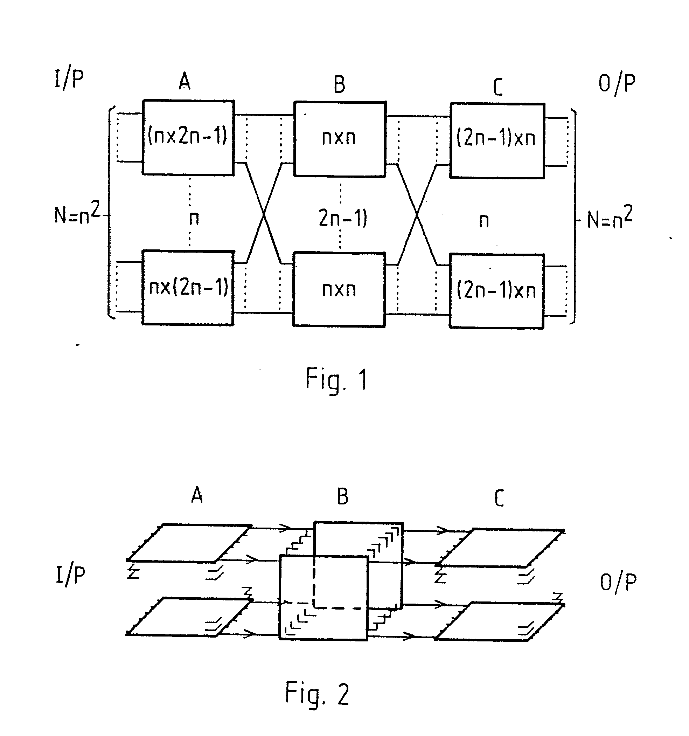

Referring now to the drawings, in Fig. 1, the three-stage network comprises three separate switch stages A, B and C. The network has $N = n^2$ inputs I/P and $N = n^2$ outputs O/P. The intermediate stage switches (B) comprise n inputs and n outputs for reasons of symmetry; 2n-1 switches are required for non-blocking operation. The input switches have n inputs and 2n-1 outputs; the output switches have 2n-1 inputs and n outputs. Each output on a first stage switch (A) is connected or is linked to a separate intermediate switch input; each input to a third stage switch (C) connects or links similarly and symmetrically to an output on a separate intermediate switch (B).

A configuration (not shown) similar to Fig. 1, is known, in which the interstage inputs and outputs are multiplexed together in groups. In this configuration, the switch itself is considered as comprising the switch matrix together with its associated multiplexers and demultiplexers. The multiplexed switch interconnections or links are formed in a way analogous to that shown in Fig. 1, and each multiplexed port on one switch connects to a multiplexed port on a separate switch on the next stage. If the multiplex ratio is M, the number of interconnections or links is reduced by M over the case where no multiplexing is employed, i.e. from $2N$-N. to $\frac{2N}{M}$ - $\frac{N}{M}$ in the three-stage example discussed here.

This invention is particularly concerned with the interstage links employed in the switching networks discussed above and to this end it is important to appreciate how such switching networks can be arranged. Fig. 2 shows how each plane of the first stage A and last stage C can be arranged in a stack and by effectively 'untwisting' the multiple crossover between stage A and B and B and C the planes of the intermediate stage B can be arranged at right angles to those in the first stage. In this way the interconnections or links can be made directly between the stages. This arrangement is known as an orthogonal switch network.

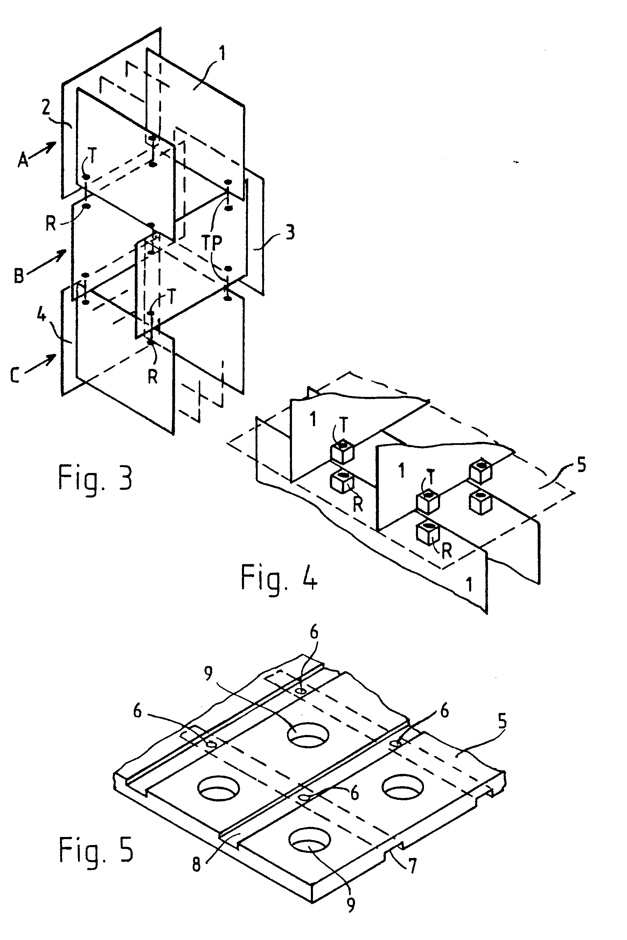

Referring now to Fig. 3 and Fig. 4 in which an orthogonal.arrangement is shown where the printed circuit boards p.c.b's 1, on which individual coordinate switches are mounted, are assembled orthogonally in 1st stage A, 2nd stage B, 3rd stage C, blocks. The boards 1, in each block are plugged into backplanes 2, 3 and 4, which are themselves arranged orthogonally. Links between boards over which signals are transmitted, can thus be made in straight line paths from each switch in a switch stage block to all other switches in the adjacent switch stage block. These short straight-line links are made optically by locating optical sources, such as electromagnetic wave transmitting means T in the form of light emitting diodes, one for each connection, on the 1st stage printed circuit board, and electromagnetic wave receiving means R in the form of optical detectors on the 2nd stage printed circuit board. The same arrangements are incorporated for links between the 2nd stage and 3rd stage boards.

Accordingly linking between switch stages is effected by means of a free space transmission path TP from transmitter T modulated with the interconnect data, to receiver R. This enables the removal of high frequency fixed interconnections from the back planes. The back plane is able to continue to carry lower frequency electrical control signals.

The transmitters T comprise directly modulated light emitting diodes which have modulation capability to beyond 1.5 GHz, and the receivers are photo detectors. Discrete transmitters and receivers can be employed in this arrangement, or alternatively, linear arrays of each particular element can be arranged on a matched pitch.

Referring now to Fig. 5, a fixed double-sided guide means 5 provides for printed circuit board location and alignment and also incorporates apertures 6 located at the coordinates of first and second sets of substantially parallel spaced-apart channel guides 7 and 8 respectively positioned at right angles to each other on opposite faces of the guide means. The apertures 6 provide the means for permitting electromagnetic wave transmission between corresponding pairs of electromagnetic wave transmitter means T and electromagnetic wave receiver means R mounted on the edges of the printed circuit boards of adjacent stage matrices by way of the transmission path TP.

The guide means also incorporate additional apertures 9 which permit air flow between the p.c.b's. Further, the orthogonal arrangement of the backplanes, one above another, also facilitates air draught cooling for efficient heat management.

The signals transmitted over the interface links can be analogue or digital, single channel or multiplexed. The multiplex can be by electrical modulation of the electromagnetic wave (e.g. frequency division, time division) or by optical wavelength division multiplexing. Thus, the arrangement permits a high degree of flexibility in the design of switch stages which may be space and/or time based.

The transmitters can alternatively be lasers which have amplitude or frequency modulation capability, or can use either of these sources with an external modulator, e.g. guided-wave electro-optic modulator with amplitude modulation capability to 20 GHz or more and can be single elements or arrays.

## Claims

1. An arrangement for linking multistage matrices, wherein for any interstage link between an output in any stage and an input in an adjacent stage in the multistage matrices, an electromagnetic wave transmitting means is provided at said output and an electromagnetic wave receiving means is provided at said input, and wherein the interstage link is constituted by an electromagnetic wave transmission path extending between said electromagnetic wave transmitting means and said electromagnetic wave receiving means.

2. An arrangement as claimed in claim 1, in which switch planes of adjacent stage matrices are arranged at right angles to each other to form an orthogonal switch network.

3. An arrangement as claimed in claim 2, in which the switch planes of each stage matrices are plugged into a backplane and wherein backplanes of adjacent stage matrices are arranged at right angles to each other in an orthogonal manner.

4. An arrangement as claimed in claim 3, in which each switch plane comprises a printed circuit board incorporating a plurality of coordinate switch means wherein adjacent stage matrices are separated by a double-sided guide means one side of which incorporates a first set of substantially parallel spaced-apart channels into which the printed circuit boards of one of said adjacent switch matrices are inserted and the other side of which incorporates a second set of substantially parallel spaced-apart channels arranged at right angles to said first set into which the printed circuit boards of the other of said adjacent stage matrices are inserted.

5. An arrangement as claimed in claim 4, in which at coordinates of said first and second sets of substantially spaced-apart channels there are provided apertures which serve to facilitate said electromagnetic wave transmission path between said adjacent stage matrices.

6. An arrangement as claimed in claim 5, in which said electromagnetic wave transmitting means and said electromagnetic wave receiving means are located along adjacent edges of said printed circuit boards corresponding pairs of electromagnetic wave transmitting means being positioned directly opposite and in alignment with respective ones of said apertures.

7. An arrangement as claimed in claim 1, in which said electromagnetic wave transmitting means is a light emitting diode which has a modulation capability of at least 1.5 GHz.

8. An arrangement as claimed in claim 1, in which said electromagnetic wave transmitting means is a laser which has amplitude or frequency modulation capabilities.

9. An arrangement as claimed in claims 7 or 8, in which a guided-wave electro-optic modulator with an amplitude modulation capability of at least 20 GHz is employed as an external modulator.

10. An arrangement as claimed in claim 1 in which the said electromagnetic wave receiving means is a photo-sensitive detector.

I/P    A    B    C    O/P

| (n×2n−1) | n×n | (2n−1)×n |

N=n² ——     n    2n−1)    n     —— N=n²

| n×(2n−1) | n×n | (2n−1)×n |

Fig. 1

A    B    C

I/P    O/P

Fig. 2

Fig. 3

Fig. 4

Fig. 5